# EUROPEAN PATENT APPLICATION

(11) **EP 4 075 568 A1**
(43) Date of publication of application: **19.10.2022**
(21) Application number: 20898139.9
(22) Date of filing: 01.12.2020
(51) Int. Cl.: H01M 10/48, H02J 7/02

(54) **ELECTRICITY STORAGE DEVICE AND ELECTRICITY STORAGE METHOD**

(30) Priority: 13.12.2019 JP 2019225843
(71) Applicant: Kyocera Corporation, Kyoto-shi Kyoto 612-8501 (JP)
(72) Inventor: KUBOTANI Tsuyoshi, Kyoto-shi, Kyoto 612-8501 (JP); SATO Masanobu, Kyoto-shi, Kyoto 612-8501 (JP); ODA Yuki, Kyoto-shi, Kyoto 612-8501 (JP); BABA Masahiro, Kyoto-shi, Kyoto 612-8501 (JP); MISHIMA Hiromitsu, Kyoto-shi, Kyoto 612-8501 (JP)
(74) Representative: TBK
(86) International application number: PCT/JP2020/044748
(87) International publication number: WO 2021/117560

(57) **Abstract**

Provided are an electricity storage device and an electricity storage method that can suppress degradation of cell batteries and balance the capacities of the cell batteries. An electricity storage device 1 includes a plurality of cell batteries C₁ to C_{M} serially connected; and a management module 2 including a balance circuit 20 that can selectively cause electricity to be discharged from each of the plurality of cell batteries, and a controller 22. The controller includes a current-voltage acquiring unit 220 that acquires a charging current and the respective voltages of the plurality of cell batteries and a balance control unit 221 that, if a determination condition and an execution condition are satisfied, determines a lowest-voltage cell battery having a lowest voltage among the plurality of cell batteries and controls the balance circuit such that electricity is discharged from the plurality of cell batteries other than the lowest-voltage cell battery for time periods in accordance with differences between the lowest voltage and the respective voltages of the cell batteries when the determination condition and the execution condition are satisfied.

## Description

### Cross-Reference to Related Application

This application claims priority of Japanese Patent Application No. 2019-225843 (filed December 13, 2019), the entire disclosure of which is hereby incorporated by reference.

### Technical Field

The present disclosure relates to an electricity storage device and an electricity storage method.

### Background Art

In the related art, a management module is known that monitors the voltages of a plurality of serially connected cell batteries. The management module detects imbalances in the cell batteries such as the batteries having different remaining capacities. Furthermore, the management module, for example, balances the capacities of the plurality of cell batteries by causing electricity to be discharged from at least one of the cell batteries. In the device described in PTL 1, a reference voltage value is set and the capacities of a plurality of cell batteries are balanced in accordance with the differences between the times taken for the voltages of the respective cells to reach the reference voltage value.

### Citation List

### Patent Literature

PTL 1: Japanese Unexamined Patent Application Publication No. 2017-162721

### Summary of Invention

An electricity storage device according to an embodiment of the present disclosure includes: a plurality of cell batteries serially connected; and a management module including a balance circuit that can selectively cause electricity to be discharged from each of the plurality of cell batteries, and a controller. The controller includes a current-voltage acquiring unit that acquires a charging current and respective voltages of the plurality of cell batteries, and a balance control unit that, if a determination condition and an execution condition are satisfied, determines a lowest-voltage cell battery having a lowest voltage among the plurality of cell batteries and controls the balance circuit such that electricity is discharged from the plurality of cell batteries other than the lowest-voltage cell battery for time periods in accordance with differences between the lowest voltage and the respective voltages of the cell batteries when the determination condition and the execution condition are satisfied.

An electricity storage method according to an embodiment of the present disclosure includes: acquiring a charging current and respective voltages of a plurality of cell batteries; determining a lowest-voltage cell battery having a lowest voltage among the plurality of cell batteries if a determination condition and an execution condition are satisfied; and causing electricity to be discharged from the plurality of cell batteries other than the lowest-voltage cell battery for time periods in accordance with differences between the lowest voltage and the respective voltages of the cell batteries when the determination condition and the execution condition are satisfied.

### Brief Description of Drawings

[Fig. 1] Fig. 1 is a diagram illustrating an example configuration of an electricity storage system including an electricity storage device according to an embodiment.
[Fig. 2] Fig. 2 is a diagram illustrating an example configuration of a balance circuit.
[Fig. 3] Fig. 3 is a diagram for explaining an imbalance in the capacities of cell batteries.
[Fig. 4] Fig. 4 is a diagram for explaining an imbalance in the capacities of cell batteries.
[Fig. 5] Fig. 5 is a diagram illustrating an example of balance control and changes in the voltages of cell batteries.
[Fig. 6] Fig. 6 is a diagram illustrating an example of balance control and changes in the voltages of cell batteries.
[Fig. 7] Fig. 7 is a flowchart illustrating an example of an electricity storage method executed by an electricity storage device according to an embodiment.
[Fig. 8] Fig. 8 is a diagram illustrating an example changes in variations of the voltages of cell batteries. Description of Embodiments

### (Configuration of Electricity Storage System)

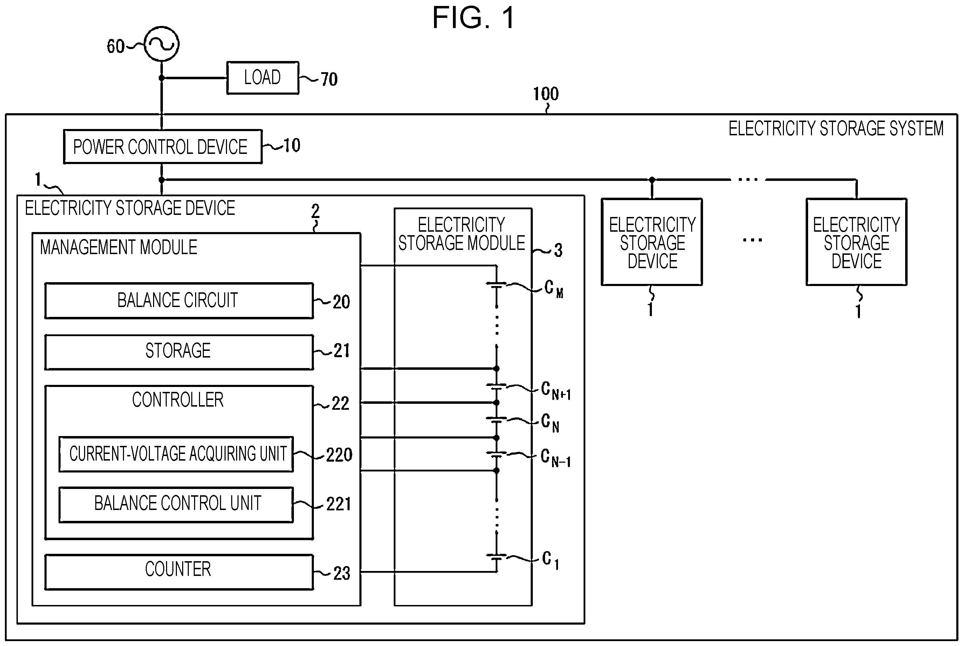

Fig. 1 is a diagram illustrating an example configuration of an electricity storage system 100 including an electricity storage device 1 according to an embodiment of the present disclosure. The electricity storage system 100 is connected to a power system 60 and supplies power to a load 70 connected to the power system 60. The load 70 may be included in an electrical appliance that consumes power such as a light, an air conditioner, or an information processing device. The electricity storage system 100 stores power supplied from the power system 60 in the electricity storage device 1.

The electricity storage system 100 includes a power control device 10 and the electricity storage device 1. The number of electricity storage devices 1 included in the electricity storage system 100 is not limited. In the example in Fig. 1, a plurality of electricity storage devices 1 are included in the electricity storage system 100, but alternatively a single electricity storage device 1 may be included in the electricity storage system 100. The plurality of electricity storage devices 1 are connected in parallel with the power control device 10. The electricity storage device 1 is connected to the power system 60 and the load 70 via the power control device 10. In this embodiment, the configurations of the plurality of electricity storage devices 1 are identical. Therefore, Fig. 1 illustrates an example configuration of a single electricity storage device 1.

The power control device 10 may also be called a power conditioning system (PCS). Furthermore, the power control device 10 may be referred to as a power conditioner. The power control device 10 controls operations of the electricity storage system 100 in an integrated manner in order to realize a variety of functions. The power control device 10, for example, controls input and output between the electricity storage devices 1, the power system 60, and the load 70. In particular, the power control device 10 controls charging of power to the electricity storage devices 1. Furthermore, the power control device 10 converts DC power supplied from the electricity storage devices 1 into AC power and outputs the AC power to the power system 60 or the load 70.

The electricity storage devices 1 store power supplied from the power system 60. The electricity storage devices 1 supply power stored in the load 70. In addition, the electricity storage devices 1 may supply to the power system 60 power that can be sold. Hereafter, "discharging" of a cell battery C_{N} of the electricity storage devices 1 refers to consuming of stored power in a balance circuit 20 during execution of balance control, which is described later, rather than supplying of power to the load 70.

### (Configuration of Electricity Storage Device)

Each electricity storage device 1 according to this embodiment includes a management module 2 and an electricity storage module 3. The management module 2 includes the balance circuit 20, a storage 21, a controller 22, and a counter 23. The controller 22 includes a current-voltage acquiring unit 220 and a balance control unit 221. Fig. 1 illustrates an example. The electricity storage device 1 does not have to include all the constituent elements illustrated in Fig. 1. Furthermore, the electricity storage device 1 may include constituent elements other than those illustrated in Fig. 1.

The electricity storage module 3 includes a plurality of cell batteries C₁ to C_{M} serially connected. Here, M is an integer greater than or equal to 2. In this embodiment, the plurality of cell batteries C₁ to C_{M} are secondary batteries. The cell battery C_{N-1}, the cell battery C_{N}, and the cell battery C_{N+1} make up some of the plurality of cell batteries C₁ to C_{M}. However, in the case where N is 1, the cell battery C_{N-1} is omitted. In addition, in the case where N is equal to M, the cell battery C_{N+1} is omitted. Furthermore, when referring to any one of the plurality of cell batteries C₁ to C_{M}, the cell battery may be referred to as a cell battery C_{N}.

The management module 2 may also be called a battery management system (BMS). The management module 2 manages the electricity storage module 3. In particular, the management module 2 monitors the voltages and currents in units of a cell battery C_{N} and suppresses variations in the capacities of the plurality of cell batteries C₁ to C_{M}.

The balance circuit 20 is a circuit that can selectively cause electricity to be discharged from each of the plurality of cell batteries C₁ to C_{M}. The balance circuit 20 causes electricity to be discharged from a specified cell battery in accordance with control performed by the balance control unit 221. In this embodiment, the balance circuit 20 can cause electricity to be discharged from one cell battery at a time. The specific configuration of the balance circuit 20 will be described later.

The storage 21 stores programs and data as a storage unit. The storage 21 temporarily stores results of processing performed by the controller 22. The storage 21 may include any suitable storage device such as a semiconductor storage device, an optical storage device, and a magnetic storage device. A semiconductor storage device may include, for example, a semiconductor memory. The storage 21 may include a plurality of types of storage devices. The storage 21 may include a combination of a portable storage medium such as a memory card and a device that reads a storage medium. Programs stored in the storage 21 include programs that make the controller 22 function as the current-voltage acquiring unit 220 and the balance control unit 221.

The controller 22 is a processor such as a central processing unit (CPU), for example. The controller 22 may be an integrated circuit such as a System-on-a-Chip (SoC) into which other constituent elements are integrated. The controller 22 may be formed by combining a plurality of integrated circuits. The controller 22 controls operations of the electricity storage device 1 in an integrated manner and realizes a plurality of functions. Specifically, the controller 22 refers to data stored in the storage 21 as necessary. The controller 22 realizes various functions by executing commands included in the programs stored in the storage 21. In this embodiment, the controller 22 realizes the functions of the current-voltage acquiring unit 220 and the balance control unit 221 by executing commands of programs read out from the storage 21.

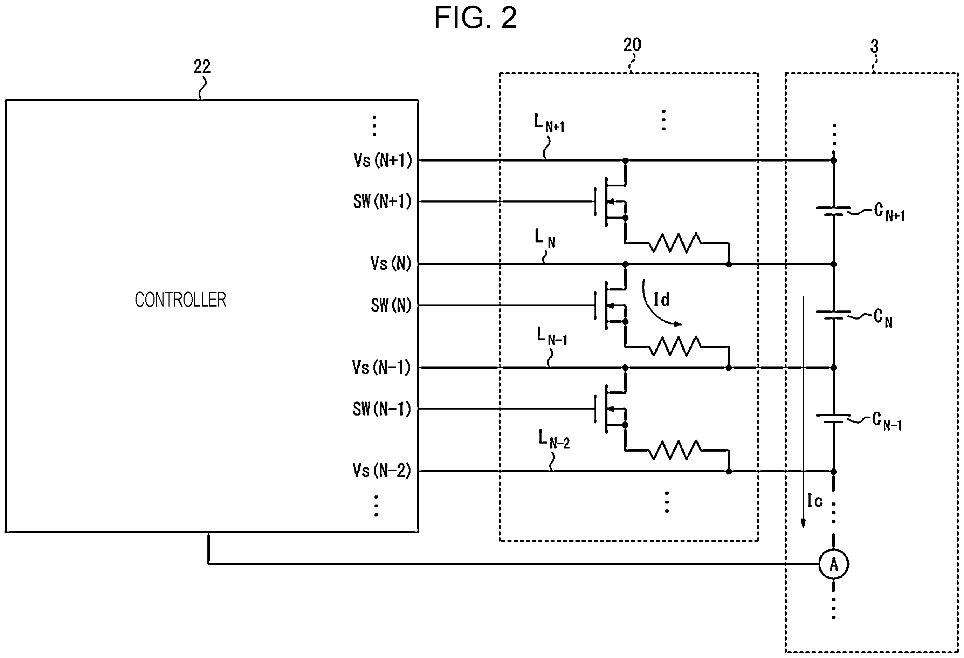

The current-voltage acquiring unit 220 acquires a charging current I_{c} (refer to Fig. 2) and the respective voltages of the plurality of cell batteries C₁ to C_{M}. The current-voltage acquiring unit 220 continuously acquires the charging current I_{c} and the respective voltages of the plurality of cell batteries C₁ to C_{M} while the electricity storage device 1 is operating. The current-voltage acquiring unit 220 outputs the obtained charging current I_{c} and voltages to the balance control unit 221.

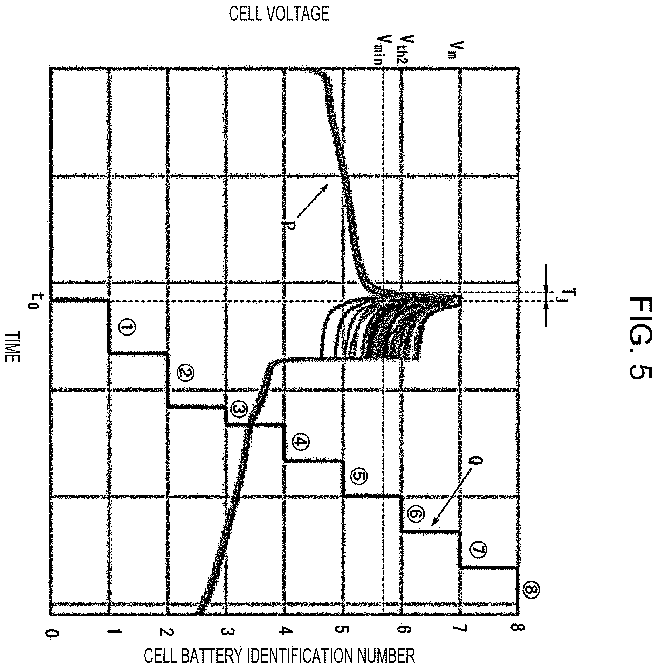

The balance control unit 221 causes electricity to be discharged from an intended cell battery C_{N} for a set discharge time period in order to suppress variations between the capacities of the plurality of cell batteries C₁ to C_{M}. Specifically, the balance control unit 221 determines a lowest-voltage cell battery having a lowest voltage Vₘᵢₙ (refer to Fig. 5) among the plurality of cell batteries C₁ to C_{M} if a determination condition and an execution condition are satisfied. The balance control unit 221 controls the balance circuit 20 such that electricity is discharged from the plurality of cell batteries C₁ to C_{M} other than the lowest-voltage cell battery for time periods in accordance with the differences between the lowest voltage Vₘᵢₙ and the voltages of the cell batteries when the determination condition and the execution condition are satisfied. The determination condition, the execution condition, and control of the balance circuit 20 will be described in detail later.

The counter 23 functions as a timer that measures a unit of time. The counter 23 may be, for example, an up counter, a down counter, or an up-down counter. The unit of time may be, for example, 10 minutes, 5 minutes, or 1 hour. The type of counter 23 and the unit of time are not limited.

Fig. 2 is a diagram illustrating an example configuration of the balance circuit 20. In this embodiment, the balance circuit 20 includes discharge circuits that each include a switch and a resistor. The balance circuit 20 is provided with a discharge circuit for each of the plurality of cell batteries C₁ to C_{M}. The switches in Fig. 2 are metal-oxide-semiconductor field-effect transistors (MOSFETs) but do not have to be MOSFETs. The gate of the MOSFET of each discharge circuit is controlled by the controller 22 and the MOSFET is switched between an on state and an off state. For example, the gate of the MOSFET of the discharge circuit of the cell battery C_{N} is connected to an SW(N) terminal of the controller 22. In the example in Fig. 2, the MOSFET of the discharge circuit of the cell battery C_{N} is switched to an on state if a high-level signal is output from the SW(N) terminal of the controller 22. Furthermore, the MOSFET of the discharge circuit of the cell battery C_{N} is switched to an off state if a low-level signal is output from the SW(N) terminal of the controller 22.

In addition, for example, the drain of the MOSFET of the discharge circuit of the cell battery C_{N} is electrically connected to a wiring line L_{N}. The drain of the MOSFET of the discharge circuit of the cell battery C_{N} is also connected to the source of the MOSFET of the discharge circuit of the cell battery C_{N+1} via a resistor. The source of the MOSFET of the discharge circuit of the cell battery C_{N} is electrically connected to a wiring line L_{N-1} via a resistor. A leakage current I_{d} flows between the drain and source when the MOSFET of the discharge circuit of the cell battery C_{N} is switched to the on state. In other words, electricity is discharged from the cell battery C_{N} and a state of charge (SOC) and the voltage of the cell battery C_{N} can be lowered when the MOSFET of the discharge circuit of the cell battery C_{N} is switched to the on state.

The wiring lines connected to the terminals of the plurality of cell batteries C₁ to C_{M} are electrically connected to the controller 22 of the management module 2. The current-voltage acquiring unit 220 of the controller 22 can acquire the respective voltages of the plurality of cell batteries C₁ to C_{M} by obtaining voltage differences between adjacent wiring lines. For example, one end of the wiring line L_{N} is connected to a Vs(N) terminal of the controller 22 via the balance circuit 20. The other end of the wiring line L_{N} is connected to a negative terminal of the cell battery C_{N+1} and a positive terminal of the cell battery C_{N}. In addition, for example, one end of the wiring line L_{N-1} is connected to a Vs(N-1) terminal of the controller 22 via the balance circuit 20. The other end of the wiring line L_{N-1} is connected to a negative terminal of the cell battery C_{N} and a positive terminal of the cell battery C_{N-1}. The current-voltage acquiring unit 220 can acquire the voltage of the cell battery C_{N} by obtaining the difference between the voltage of the wiring line L_{N} and the voltage of the wiring line L_{N-1}.

Furthermore, the electricity storage device 1 charges the electricity storage module 3 with power in accordance with control performed by the power control device 10. Fig. 2 illustrates the electricity storage module 3 during charging and the charging current I_{c} flows through the plurality of cell batteries C₁ to C_{M}. The current-voltage acquiring unit 220 acquires the charging current I_{c} by accepting a signal from a current sensor provided in series with the plurality of cell batteries C₁ to C_{M}, for example.

### (Balancing of Capacities)

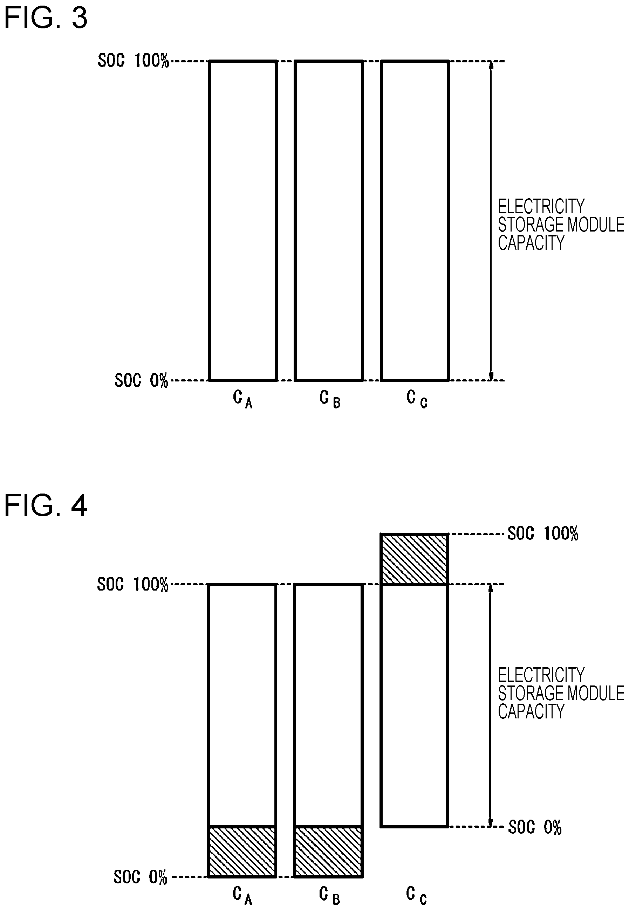

Figs. 3 and 4 are diagrams for explaining an imbalance in the capacities of the plurality of cell batteries C₁ to C_{M}. In Figs. 3 and 4, three cell batteries, namely, a cell battery C_{A}, a cell battery C_{B}, and a cell battery C_{C} among the plurality of cell batteries C₁ to C_{M} are used in the explanation. Fig. 3 illustrates an example of the initial states of the SOCs of the cell battery C_{A}, the cell battery C_{B}, and the cell battery Cc. For example, at the time of product shipment of the electricity storage module 3, the SOC levels of the cell battery C_{A}, the cell battery C_{B}, and the cell battery C_{C} are uniform. For example, when the cell battery C_{B} has an SOC of p% (0 ≤ p ≤ 100), the SOCs of the cell battery C_{A} and the cell battery C_{C} are also p%. At this time, in the electricity storage module 3 as a whole, all the capacities of the cell battery C_{A}, the cell battery C_{B}, and the cell battery C_{C} can be used. The state illustrated in Fig. 3 is a state in which the capacities are balanced.

However, in general, as charging and discharging are repeated in the electricity storage module 3 , the SOC levels of some of the cell batteries may shift. Fig. 4 illustrates an example of the states of the cell battery C_{A}, the cell battery C_{B}, and the cell battery C_{C} after charging and discharging have been repeated in the electricity storage module 3 from the state in Fig. 3. In the example in Fig. 4, the level of the SOC of the cell battery C_{C} is shifted from that of the cell battery C_{A} and that of the cell battery C_{B}. The state illustrated in Fig. 4 is a state in which the capacities are imbalanced. The shift in the charged state represented by the cell battery C_{C} in Fig. 4 is called an SOC shift.

In the case where an SOC shift has occurred, when the electricity storage module 3 is charged, charging is completed when the SOC of the cell battery C_{A} and the SOC of the cell battery C_{B} reach 100%. Therefore, the cell battery C_{C} cannot be charged to an SOC of 100%. Then, when power is supplied to the load 70 from the electricity storage module 3, the cell battery C_{C} having the lower charged amount reaches an SOC of 0% more quickly than the other cell batteries C_{A} and C_{B}. Therefore, as illustrated in Fig. 4, the usable capacity of the electricity storage module 3 as a whole is significantly reduced from that in the initial state. if the electricity storage device 1 detects an imbalance in the capacities, it is necessary to execute balance control, i.e., processing for balancing the capacities of the plurality of cell batteries C₁ to C_{M}.

### (Balance Control)

In the example in Figs. 3 and 4, balance control is performed by causing electricity to be discharged from the cell battery C_{A} and the cell battery C_{B}, which reach an SOC of 100% earlier during charging. In other words, balance control is performed by discharging electricity from the cell batteries other than the cell battery C_{C} having the lowest voltage Vₘᵢₙ. When electricity is discharged from the cell battery C_{A} and the cell battery C_{B} during charging of the electricity storage module 3, the time taken until charging is complete becomes longer, and therefore the level at which the SOCs of the cell battery C_{A} and the cell battery C_{B} are 100% and the level at which the SOC of the cell battery C_{C} is 100% come closer together. Furthermore, when electricity is discharged from the cell battery C_{A} and the cell battery C_{B} while power is supplied to the load 70, the power consumption of the cell battery C_{A} and the cell battery C_{B} is larger than that of the cell battery Cc, and therefore the level at which the SOCs of the cell battery C_{A} and the cell battery C_{B} is 0% and the level at which the SOC of the cell battery C_{C} is 0% come closer together. Capacity variations are gradually reduced as charging-discharging cycles are repeatedly performed while executing the balance control.

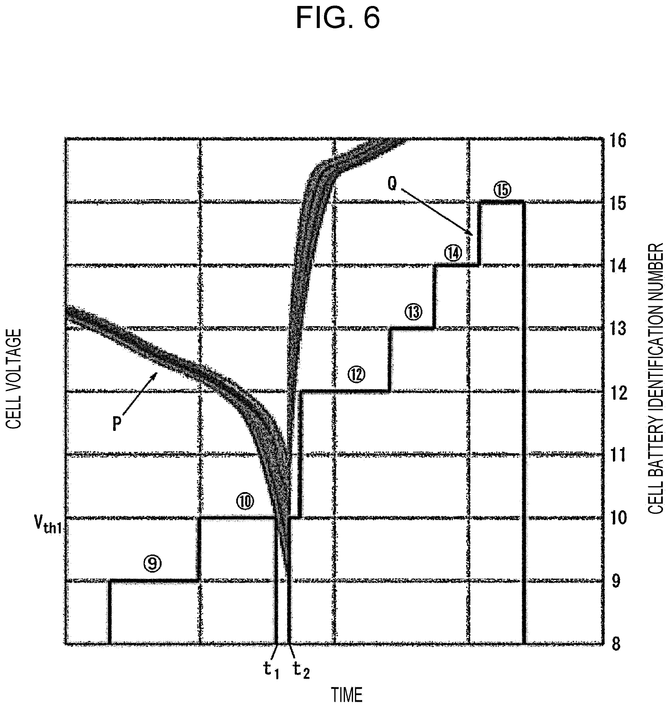

Based on the above-described principles, the electricity storage device 1 of this embodiment executes balance control as described below. Figs. 5 and 6 are diagrams illustrating an example of balance control and changes that occur in the voltages of the plurality of cell batteries C₁ to C_{M}. The horizontal axis in Figs. 5 and 6 represents time. The vertical axis represents the voltages of the cell batteries and the identification numbers of the cell batteries. Curves P represent changes in the voltages of the plurality of cell batteries C₁ to C_{M}. In addition, a solid line Q shaped like a staircase indicates, with identification numbers, cell batteries from which electricity is being discharged. In the example in Figs. 5 and 6, M, which indicates the total number of cell batteries, is 16. The subscript numbers of the plurality of cell batteries C₁ to C_{M} are used as their identification numbers.

In Fig. 5, the electricity storage device 1 charges the electricity storage module 3 with power until a time to in accordance with control performed by the power control device 10. The time t₀ is the time at which at least one of the voltages of the plurality of charging cell batteries C₁ to C_{M} has reached a set voltage upper limit Vm. The voltage upper limit Vm is 3.6 [V], for example. The determination condition is satisfied in a period Tⱼ before the time to. The balance control unit 221 determines a lowest-voltage
cell battery having a lowest voltage Vₘᵢₙ among the plurality of cell batteries C₁ to C_{M} if the determination condition and the execution condition are satisfied. In the example in Figs. 5 and 6, the lowest-voltage cell battery is the cell battery C₁₆ having an identification number of 16.

The determination condition is a condition for determining whether or not data necessary for determining whether to perform balancing control is present. The electricity storage device 1 determines an imbalance in the capacities of the cell batteries during the period Tⱼ in which the determination condition is satisfied. In this embodiment, the determination condition includes at least one of the voltages of the plurality of cell batteries C₁ to C_{M} being greater than or equal to a second voltage threshold Vₜₕ₂ (condition A), the charging current I_{c} being greater than a first current threshold (condition B), and the charging current I_{c} being less than or equal to a second current threshold (condition C). The second voltage threshold Vₜₕ₂ is a threshold for detecting that charging is nearing completion and is defined on the basis of the voltage upper limit Vm. The second voltage threshold Vₜₕ₂ is 3.5 [V], for example. The first current threshold is a threshold for detecting that the electricity storage module 3 is being charged and that the charging current I_{c} is flowing. The first current threshold is 0.5 [A], for example. The second current threshold is a threshold for detecting that charging of the electricity storage module 3 is being executed normally. The second current threshold is 1.0 [A], for example. In this embodiment, if the condition A, condition B, and condition C are all satisfied, the determination condition is satisfied. In another embodiment, part (for example, condition C) of the determination condition does not have to be included. In addition, in another embodiment, the determination condition may include further additional conditions.

The execution condition is a condition for determining whether an imbalance has occurred in the capacities of the cell batteries, i.e., whether or not to execute balance control. The electricity storage device 1 executes balance control if the execution condition is satisfied. In this embodiment, the execution condition includes the magnitude of a difference between the voltages of the plurality of cell batteries C₁ to C_{M} being greater than or equal to a third voltage threshold when the above determination condition is satisfied. In other words, if a difference obtained by subtracting the smallest value from the largest value of the voltages of the plurality of cell batteries C₁ to C_{M} acquired by the current-voltage acquiring unit 220 in the period Tⱼ in which the determination condition is satisfied is greater than or equal to the third voltage threshold, the execution condition is satisfied. The third voltage threshold is determined on the basis of voltage variations caused by unacceptable SOC shifts in the specifications of the electricity storage device 1. The third voltage threshold is 0.1 [V], for example.

The balance control unit 221 sets the discharge time periods of the plurality of cell batteries C₁ to C_{M} except for the lowest-voltage cell battery. Here, a discharge time period is the time period for which discharging is performed on an intended cell battery from which electricity is discharged by the balance circuit 20, specifically, the time period for which the balance control unit 221 turns on the switch of the discharge circuit to which the intended cell battery is connected. In the example in Figs. 5 and 6, the balance control unit 221 sets discharge time periods of the cell batteries C_{N} (N = 1 to 15) other than the cell battery C₁₆, which is the cell battery having the lowest voltage. The discharge time periods are set in accordance with the differences between the voltages of the cell batteries C_{N} for which the determination condition and the execution condition are satisfied and the lowest voltage Vₘᵢₙ of the cell battery C₁₆. Hereafter, the differences between the voltages of the cell batteries C_{N} and the lowest voltage Vₘᵢₙ in this case are referred to as voltage differences ΔV. In order to reduce a capacity imbalance as quickly as possible, the discharge time periods are set so as to be longer when the voltage differences ΔV are larger.

The balance control unit 221 may set the discharge time periods on the basis of the unit time measured by the counter 23. In this case, the balance control unit 221 can effectively manage the discharge time periods of the plurality of cell batteries C₁ to C_{M} using a single counter 23. In the case where discharging is stopped and restarted as described later, the balance control unit 221 can properly manage the remaining discharge time periods of the stopped cell batteries by matching stopping and restarting of operation of the counter 23 with stopping and restarting of discharging of the cell batteries. In the example in Figs. 5 and 6, the unit time is 10 minutes. The balance control unit 221 sets the discharge time period to 30 minutes if the voltage difference ΔV is greater than 150 [mV]. The balance control unit 221 sets the discharge time period to 20 minutes if the voltage difference ΔV is greater than 100 [mV] and less than or equal to 150 [mV]. The balance control unit 221 sets the discharge time period to 10 minutes if the voltage difference ΔV is greater than 50 [mV] and less than or equal to 100 [mV]. The balance control unit 221 sets the discharge time period to 0 minutes if the voltage difference ΔV is greater than or equal to 0 [mV] and less than or equal to 50 [mV]. In the example in Figs. 5 and 6, the discharge time periods of the cell batteries C₁, C₂, and C₈ are set to 30 minutes. The discharge time periods of the cell batteries C₄ to C₇ and C₉ to C₁₂ are set to 20 minutes. The discharge time periods of the cell batteries C₃ and C₁₃ to C₁₅ are set to 10 minutes.

The balance control unit 221 controls the balance circuit 20 in accordance with the intended cell batteries from which electricity is discharged and the discharge time periods set as described above. In other words, the balance control unit 221 executes balance control. The balance control unit 221 controls the balance circuit 20 such that electricity is discharged from the plurality of cell batteries other than the lowest-voltage cell battery in a predetermined order. In this embodiment, the balance control unit 221 executes discharging of the cell batteries in the order of the identification numbers of the cell batteries. As illustrated in Fig. 5, discharging of the cell battery C₁ is executed for 30 minutes, and then discharging of the cell battery C₂ is executed for 30 minutes, and after that, discharging is executed in the order of the identification numbers. The predetermined order is not limited to the order of the identification numbers of the cell batteries. For example, as another embodiment, discharging of the cell batteries may be performed in descending order of discharge time period.

The balance control unit 221 controls the balance circuit 20 so as to stop discharging of the plurality of cell batteries C₁ to C_{M} if at least one voltage out of the voltages of the plurality of cell batteries C₁ to C_{M} is smaller than a first voltage threshold Vₜₕ₁. The first voltage threshold Vₜₕ₁ is a threshold for detecting a situation in which excessive discharging may occur. The first voltage threshold Vₜₕ₁ is 3.0 [V], for example. As illustrated in Fig. 6, balance control is stopped because at least one of the voltages of the plurality of cell batteries C₁ to C_{M} has fallen below the first voltage threshold Vₜₕ₁ at a time ti. Thus, the electricity storage device 1 can avoid a situation in which excessive discharging occurs during the balance control.

Furthermore, the balance control unit 221 may restart balance control that has been stopped once charging of the electricity storage module 3 has restarted. The balance control unit 221 controls the balance circuit 20 so as to cause the plurality of cell batteries C₁ to C_{M} that have stopped discharging to restart discharging if all of the voltages of the plurality of cell batteries C₁ to C_{M} are greater than or equal to the first voltage threshold Vₜₕ₁ and the charging current I_{c} is greater than or equal to the first current threshold. As described above, the first current threshold is a threshold for detecting that the electricity storage module 3 is being charged and that the charging current I_{c} is flowing. The first current threshold is 0.5 [A], for example. As illustrated in Fig. 6, charging of the electricity storage module 3 is restarted between the time ti and a time t₂ and the voltages of the plurality of cell batteries C₁ to C_{M} rise. When all of the voltages of the plurality of cell batteries C₁ to C_{M} become greater than or equal to the first voltage threshold Vₜₕ₁ at the time t₂, discharging of the cell battery C₁₀, which was stopped, is restarted, and after that discharging is executed in order of the identification numbers up to the cell battery C₁₅.

### (Electricity Storage Method)

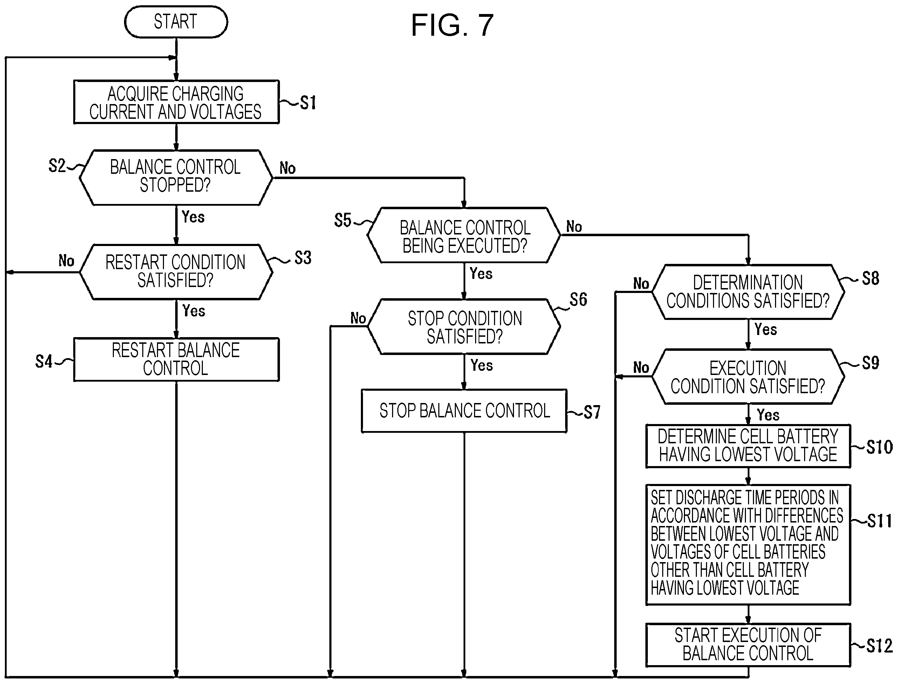

Fig. 7 is a flowchart illustrating an example of an electricity storage method executed by the electricity storage device 1. The electricity storage device 1 executes integrated control of the electricity storage device 1 including the above-described balance control in accordance with the flowchart illustrated in Fig. 7.

The controller 22 of the electricity storage device 1 acquires the charging current I_{c} and the respective voltages of the plurality of cell batteries C₁ to C_{M} (step S1). The charging current I_{c} and the voltages are continuously acquired while the electricity storage device 1 is operating.

The controller 22 of the electricity storage device 1 advances to the processing of step S3 in the case where balance control is stopped (Yes in step S2). As illustrated in Fig. 6, stopping of balance control occurs when at least one of the voltages of the plurality of cell batteries C₁ to C_{M} falls below the first voltage threshold Vₜₕ₁.

In the case where a restart condition is not satisfied (No in step S3), the controller 22 of the electricity storage device 1 returns to the processing of step S1.
Here, the restart condition is that all of the voltages of the plurality of cell batteries C₁ to C_{M} are greater than or equal to the first voltage threshold Vₜₕ₁ and that the charging current I_{c} is greater than or equal to the first current threshold.

In the case where the restart condition is satisfied (Yes in step S3), the controller 22 of the electricity storage device 1 restarts the balance control (step S4) and returns to the processing of step S1. Here, restarting the balance control specifically means restarting discharging of the plurality of cell batteries C₁ to C_{M} that were stopped.

The controller 22 of the electricity storage device 1 advances to the processing of step S5 in the case where balance control is not stopped (No in step S2).

The controller 22 of the electricity storage device 1 advances to the processing of step S6 in the case where balance control is being executed (Yes in step S5). Here, the balance control is executed means that discharging of the plurality of cell batteries C₁ to C_{M} other than the lowest-voltage cell battery is executed for the set discharge time periods.

In the case where the stop condition is not satisfied (No in step S6), the controller 22 of the electricity storage device 1 returns to the processing of step S1.
Here, the stop condition is that at least one of the voltages of the plurality of cell batteries C₁ to C_{M} is smaller than the first voltage threshold Vₜₕ₁.

In the case where the stop condition is satisfied (Yes in step S6), the controller 22 of the electricity storage device 1 stops the balance control (step S7) and returns to the processing of step S1.

The controller 22 of the electricity storage device 1 advances to the processing of step S8 in the case where balance control is not being executed (No in step S5).

In the case where the determination condition is not satisfied (No in step S8), the controller 22 of the electricity storage device 1 returns to the processing of step S1. Here, the determination condition includes at least one out of the voltages of the plurality of cell batteries C₁ to C_{M} being greater than or equal to the second voltage threshold Vₜₕ₂, the charging current I_{c} being greater than or equal to the first current threshold, and the charging current I_{c} being less than or equal to the second current threshold.

In the case where the determination condition is satisfied (Yes in step S8), the controller 22 of the electricity storage device 1 advances to the processing of step S9.

In the case where an execution condition is not satisfied (No in step S9), the controller 22 of the electricity storage device 1 returns to the processing of step S1. Here, the execution condition includes the magnitude of a difference between the voltages of the plurality of cell batteries C₁ to C_{M} being greater than or equal to a third voltage threshold if the above determination condition is satisfied.

In the case where the execution condition is satisfied (Yes in step S9), the controller 22 of the electricity storage device 1 determines a lowest-voltage cell battery (step S10). The lowest-voltage cell battery is the cell battery that has the lowest voltage Vₘᵢₙ among the plurality of cell batteries C₁ to C_{M}.

The controller 22 of the electricity storage device 1 sets the discharge time periods in accordance with the differences between the lowest voltage Vₘᵢₙ and the voltages of the cell batteries other than the lowest-voltage cell battery (step S11).

The controller 22 of the electricity storage device 1 initiates execution of the balance control (step S12) and returns to the processing of step S1.

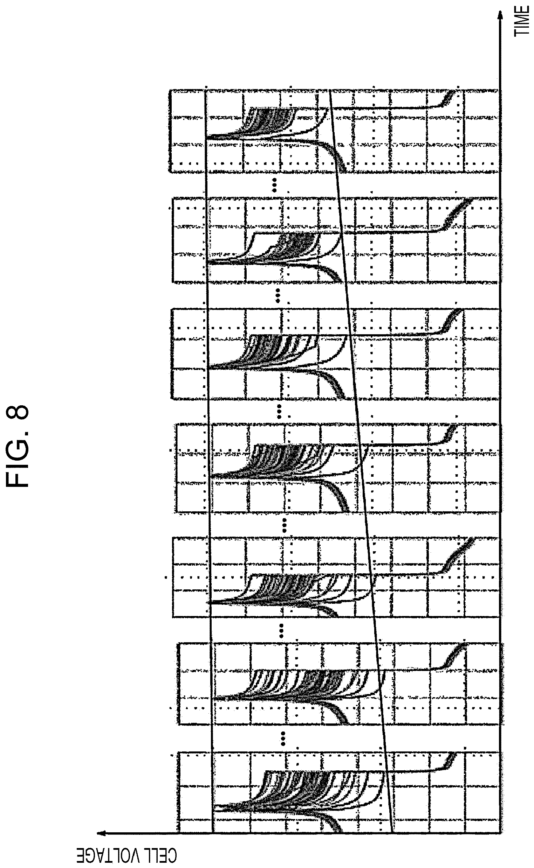

Fig. 8 is a diagram illustrating an example of changes that occur in variations in the voltages of the plurality of cell batteries C₁ to C_{M} in an experiment in which the electricity storage device 1 executes the above-described electricity storage method and repeatedly executes charging-discharging cycles. Curves P in Fig. 8 are the same as in Figs. 5 and 6. As illustrated in Fig. 8, when the charging-discharging cycles are repeatedly performed, variations in the voltages of the plurality of cell batteries C₁ to C_{M} become gradually smaller. In other words, variations in the capacities of the plurality of cell batteries C₁ to C_{M} become smaller.

As described above, the electricity storage device 1 according to this embodiment can balance the capacities of the cell batteries using the above-described configuration. Furthermore, the problem of the related art in which, for example, all the cell batteries continue to be charged until reaching a reference voltage value and therefore may be degraded due to being excessively charged does not occur in the electricity storage device 1 according to this embodiment. Therefore, degradation of the cell batteries can be suppressed compared to the related art.

An embodiment has been described on the basis of the drawings and examples, but it should be noted that various modifications and amendments may be made by one skilled in the art on the basis of the present disclosure. Therefore, it should be noted that such modifications and amendments are included within the scope of the present disclosure.
For example, the functions and so on included in each component, each means, each step and so forth can be rearranged in a logically consistent manner, and a plurality of means and/or steps and so forth can be combined into a single means and/or step or divided into separate means and/or steps.

For example, in the above-described embodiment, as illustrated in Fig. 1, the electricity storage device 1 is described as a single device. However, the electricity storage device 1 of the present disclosure is not limited to being a single device and may include a plurality of independent devices.

In the present disclosure, "first", "second," and so on are identifiers used to distinguish between such configurations. Regarding the configurations, "first", "second", and so on used to distinguish between the configurations in the present disclosure may be exchanged with each other. Exchanging of the identifiers take places simultaneously. Even after exchanging the identifiers, the configurations are distinguishable from each other. The identifiers may be deleted. The configurations that have had their identifiers deleted are distinguishable from each other by symbols. The use of identifiers such as "first" and "second" alone in this disclosure should not be used as a basis for interpreting the order of such configurations or the existence of identifiers with smaller numbers.

Sustainable development goals (SDGs) are 17 international goals adopted at a UN Summit held in September 2015. The electricity storage device 1 and the electricity storage method according to the embodiment can contribute to achieving, for example, "7. Affordable and clean energy", "9. Industry, innovation and infrastructure", and "11. Sustainable cities and communities" among the 17 SDGs. Reference Signs List

- 1: electricity storage device
- 2: management module
- 3: electricity storage module
- 10: power control device
- 20: balance circuit
- 21: storage
- 22: controller
- 23: counter
- 60: power system
- 70: load
- 100: electricity storage system
- 220: current-voltage acquiring unit
- 221: balance control unit

## Claims

1. An electricity storage device comprising:
a plurality of cell batteries serially connected; and
a management module including a balance circuit capable of selectively causing electricity to be discharged from each of the plurality of cell batteries, and a controller,
wherein the controller includes
a current-voltage acquiring unit that acquires a charging current and respective voltages of the plurality of cell batteries, and
a balance control unit that, if a determination condition and an execution condition are satisfied, determines a lowest-voltage cell battery having a lowest voltage among the plurality of cell batteries and controls the balance circuit such that electricity is discharged from the plurality of cell batteries other than the lowest-voltage cell battery for time periods in accordance with differences between the lowest voltage and the respective voltages of the cell batteries when the determination condition and the execution condition are satisfied.

2. The electricity storage device according to Claim 1, wherein the balance control unit controls the balance circuit such that discharge of electricity from the plurality of cell batteries is caused to stop if at least one of the voltages of the plurality of cell batteries is lower than a first voltage threshold.

3. The electricity storage device according to Claim 2,
wherein the balance control unit controls the balance circuit such that the discharge of electricity from the plurality of cell batteries, which was stopped, is caused to restart if the voltages of the plurality of cell batteries are all greater than or equal to the first voltage threshold and the charging current is greater than or equal to a first current threshold.

4. The electricity storage device according to any one of Claims 1 to 3,
wherein the determination condition includes at least one of the voltages of the plurality of cell batteries being greater than or equal to a second voltage threshold, the charging current being greater than or equal to a first current threshold, and the charging current being less than or equal to a second current threshold.

5. The electricity storage device according to any one of Claims 1 to 4,
wherein the execution condition includes a magnitude of a difference between the voltages of the plurality of cell batteries when the determination condition is satisfied being greater than or equal to a third voltage threshold.

6. The electricity storage device according to any one of Claims 1 to 5,
wherein the management module includes a counter that measures a unit time, and
the balance control unit sets, based on the unit time, time periods for which electricity is discharged from the plurality of cell batteries other than the lowest-voltage cell battery.

7. The electricity storage device according to any one of Claims 1 to 6,
wherein the balance circuit is capable of causing electricity to be discharged from one of the cell batteries at a time, and
the balance control unit controls the balance circuit such that electricity is discharged from the plurality of cell batteries other than the lowest-voltage cell battery in a predetermined order.

8. An electricity storage method comprising:
acquiring a charging current and respective voltages of a plurality of cell batteries;
determining a lowest-voltage cell battery having a lowest voltage among the plurality of cell batteries if a determination condition and an execution condition are satisfied; and
causing electricity to be discharged from the plurality of cell batteries other than the lowest-voltage cell battery for time periods in accordance with differences between the lowest voltage and the respective voltages of the cell batteries when the determination condition and the execution condition are satisfied.
